# EUROPEAN PATENT SPECIFICATION

(11) **EP 2 610 909 B1**
(45) Date of publication and mention of the grant of the patent: **08.05.2019**
(21) Application number: 12179922.5
(22) Date of filing: 09.08.2012
(51) Int. Cl.: H01L 25/075

(54) **LED lighting device with high color rendering index**
LED Beleuchtungsvorrichtung mit hohem Farbdarstellungsindex
Dispositif d'éclairage à diodes électroluminescentes avec un indice de rendu des couleurs élévé

(30) Priority: 28.12.2011 CN 201110447718
(43) Date of publication of application: 03.07.2013
(73) Proprietor: Shanghai Sansi Electronics Engineering Co., Ltd., Shanghai 201100 (CN); Shanghai Sansi Technology Co., Ltd, Shanghai 201100 (CN); Jiashan Sansi Photoelectricity Technology Co., Ltd., Jiaxing City, Zheijang 314113 (CN)
(72) Inventor: Chen, Bishou, 201100 Minhang District (CN); Chen, Chungen, 201100 Minhang District (CN); Feng, Na, 201100 Minhang District (CN); Chen, Min, 201100 Minhang District (CN)
(74) Representative: Sun, Yiming

(56) References cited:
- WO-A1-2011/036612
- WO-A2-2007/142948
- US-A1- 2004 217 364
- US-A1- 2004 218 387
- US-A1- 2007 139 920

## Description

### Background of the Present Invention

### Field of Invention

The present invention relates to the LED (light emitting diode) lighting field, and more particularly to an LED lighting device with high color rendering index.

### Description of Related Arts

A lot of energy is consumed in the lighting field around the world every year. Incandescent lamps appeared in the late 19^{th} century, and their luminous efficiency is only 8-151m/w. Due to the low luminous efficiency, incandescent lamps have been restricted and even prohibited by most countries nowadays. The luminous efficiency of fluorescent lamps is many times higher than that of incandescent lamps, so fluorescent lamps have become the most widely used lighting source instead of incandescent lamps. However, fluorescent lamps contain the toxic mercury element, so that some countries have already begun to restrict the application fields of fluorescent lamps.

As an emerging energy field, the LED light source has the advantages of high luminous efficiency and green environmental protection which are recognized by people and is applied to many lighting fields instead of the traditional light source. In the lighting field, the color rendering index is used to indicate that the light emitted by the source correctly reflects the color of the object. The higher the color rendering index of the light source is, the smaller the chromatic aberration which reflects the color of the object is. It can be said that the color rendering index is an important parameter of the quality of the light source, and it determines the application range of the light source. Therefore, it has become an important task and goal to improve the color rendering index in the lighting field under the requirements of high luminous efficiency and no pollution. However, due to the characteristics of the LED itself, the color rendering index of the monochromatic LED is low, white light formed by mixing the polychromatic light is generally used as the light source. Currently, LED white light with high power appears in the LED bottom encapsulation field. Its color rendering index is higher and can reach 90 or more, whereas there is no doubt that it is expensive and its application cost is very high. Therefore, the color rendering index is improved by mixing light in most LED application fields.

WO 2011/036612 A1, US 2007/0139920 A1, US 2004/0217364 A1, US 2004/0218387 A1 and WO 2007/142948 A2 discloses prior art LED lighting devices.

### Summary of the Present Invention

Preferably, an object of the present invention is to provide an LED lighting device with high color rendering index, wherein the color rendering index of the LED lighting device can be improved by selecting a variety of LEDs within a certain spectral range to mix light.

Preferably, in order to accomplish the above object, the present invention provides an LED (light emitting diode) lighting device with high color rendering index, comprising a plurality of LED luminous units, wherein one of the LED luminous units has (u', v') chromaticity coordinates defined on a 1976CIE chromaticity diagram, a distance between every two coordinate points is not less than 0.01, a distance between at least one of the coordinate points and any other coordinate point is not less than 0.1, and coordinates of at least one of the coordinate points meet a condition that 0.10 ≤ u' ≤ 0.45 and 0.30 ≤ v' ≤ 0.50.

According to the invention, the number of the LED luminous units is at least 5.

Preferably, the number of the LED luminous units is at least 10.

Preferably, the number of the LED luminous units is at least 20.

Preferably, the number of the LED luminous units is at least 30.

Preferably, the coordinates of at least one of the LED luminous units meet a condition that 0.10 ≤ u' ≤ 0.40 and 0.40 ≤ v' ≤ 0.50.

Preferably, the coordinates of at least one of the LED luminous units meet a condition that 0.10 ≤ u' ≤ 0.30 and 0.40 ≤ v' ≤ 0.50.

Preferably, the coordinates of at least one of the LED luminous units meet a condition that 0.15 ≤ u' ≤ 0.25 and 0.40 ≤ v' ≤ 0.50.

The 1976CIE chromaticity diagram covers all light within the spectral range in the form of the chromaticity coordinates. By selecting a plurality of chromaticity coordinates located within a certain range in the chromaticity diagram according to certain rules, the LED luminous units, represented by a plurality of chromaticity coordinates, of the present invention are mixed together, thereby forming the light source of the LED lighting device, which is capable of effectively improve the color rendering index of the LED lighting device. Moreover, while mixing light, the performance, price and other factors of a single LED can be comprehensively considered. Accordingly, the technical scheme with high performance-price ratio can be filtered out in the various optional technical schemes.

These and other objectives, features, and advantages of the present invention will become apparent from the following detailed description, the accompanying drawings, and the appended claims.

### Brief Description of the Drawings

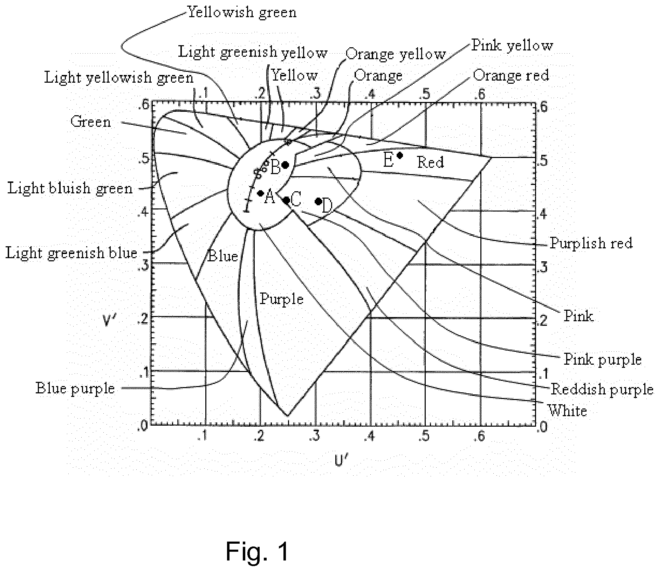

Fig. 1 ("the drawing") is a position schematic view of every LED luminous unit of an LED lighting device with high color rendering index in the chromaticity diagram according to a preferred embodiment of the present invention.

### Detailed Description of the Preferred Embodiment

The present invention is further explained in detail with the accompanying drawing.

Referring to the Fig. 1, an LED (light emitting diode) lighting device with high color rendering index according to a preferred embodiment of the present invention is illustrated, wherein the light source of the LED lighting device is formed by mixing a plurality of LED luminous units together. The selective rule of the LED luminous unit is based on the chromaticity coordinates of the chromaticity diagram. The concrete scheme is described as below. In the chromaticity coordinates, the distance between every two coordinate points is not less than 0.01, which shows that the color of the light emitted by every LED luminous unit has the visually discernible color difference, that is to say, every LED luminous unit has different colors. The distance between at least one coordinate point and any other coordinate point is not less than 0.1, which ensures that the color gamut among the coordinate points has a wider range, and the optional color of every LED luminous unit has a wider range. Therefore, the adjustable range of the color rendering index of the mixed LED luminous units is larger.

Generally, the richer light source color the lighting device contains, namely, the greater the number of the selected LED luminous units is, the wider range the selected LED luminous units has, the higher color rendering index the lighting device obtains. However, in the chromaticity diagram, the nearer the point to the curve edge, the more narrow the light spectrum is, the higher the color purity is, so that the edge point represents the monochromatic light. Usually, the higher the purity of the monochromatic light, the lower the color rendering index of the monochromatic light. Therefore, in the selected LED luminous units of the lighting device according to the preferred embodiment of the present invention, the coordinates of at least one of the LED luminous units meet the condition that 0.10 ≤ u' ≤ 0.45, and 0.30 ≤ v' ≤ 0.50.

In the drawing of the present invention, the light source of the lighting device is formed by five LED luminous units which are respectively represented by A, B, C, D and E, with the chromaticity coordinates of A(0.20, 0.43), B(0.25, 0.48), C(0.25, 0.41), D(0.30, 0.45) and E(0.45, 0.48), respectively, in the chromaticity diagram. In the preferred embodiment of the present invention, at least five LED luminous units mentioned above are mixed together, so that the color rendering index of the lighting device reaches 98.

One skilled in the art will understand that the embodiment of the present invention as shown in the drawings and described above is exemplary only and not intended to be limiting.

It will thus be seen that the objects of the present invention have been fully and effectively accomplished. Its embodiments have been shown and described for the purposes of illustrating the functional and structural principles of the present invention and is subject to change without departure from such principles. Therefore, this invention includes all modifications encompassed within the scope of the following claims.

## Claims

1. An LED (light emitting diode) lighting device with high color rendering index, comprising at least 5 LED luminous units, wherein each of the LED luminous units has (u', v') chromaticity coordinates defined on a 1976CIE chromaticity diagram, wherein a distance between every two coordinate points is not less than 0.01, a distance between at least one of the coordinate points and any other coordinate point is not less than 0.1, and **characterised in that** coordinates of at least one of the coordinate points meet a condition that 0.10 ≤ u' ≤ 0.45 and 0.30 ≤ v' ≤ 0.50.

2. The LED lighting device with high color rendering index, as recited in claim 1, wherein the number of the LED luminous units is at least 10.

3. The LED lighting device with high color rendering index, as recited in claim 1, wherein the number of the LED luminous units is at least 20.

4. The LED lighting device with high color rendering index, as recited in claim 1, wherein the number of the LED luminous units is at least 30.

5. The LED lighting device with high color rendering index, as recited in one of claims 1 to 4, wherein the coordinates of at least one of the LED luminous units meet a condition that 0.10 ≤ u' ≤ 0.40 and 0.40 ≤ v' ≤ 0.50.

6. The LED lighting device with high color rendering index, as recited in one of claims 1 to 4, wherein the coordinates of at least one of the LED luminous units meet a condition that 0.10 ≤ u' ≤ 0.30 and 0.40 ≤ v' ≤ 0.50.

7. The LED lighting device with high color rendering index, as recited in one of claims 1 to 4, wherein the coordinates of at least one of the LED luminous units meet a condition that 0.15 ≤ u' ≤ 0.25 and 0.40 ≤ v' ≤ 0.50.

## Patentansprüche

1. LED (Leuchtdiode)-Beleuchtungsvorrichtung mit hohem Farbwiedergabeindex, umfassend mindestens 5 LED-Leuchteinheiten, wobei jede der LED-Leuchteinheiten (u', v') Farbraumkoordinaten hat, die auf einem 1976CIE Farbraumdiagramm definiert sind, wobei ein Abstand zwischen jeweils zwei Koordinatenpunkten nicht weniger als 0,01 ist, ein Abstand zwischen mindestens einem der Koordinatenpunkte und irgendeinem anderen Koordinatenpunkt nicht weniger als 0,1 ist und **dadurch gekennzeichnet, dass** Koordinaten von mindestens einem der Koordinatenpunkte eine Bedingung erfüllen, dass 0,10 ≤ u' ≤ 0,45 und 0,30 ≤ v' ≤ 0,50 ist.

2. LED-Beleuchtungsvorrichtung mit hohem Farbwiedergabeindex nach Anspruch 1, wobei die Zahl der LED-Leuchteinheiten mindestens 10 ist.

3. LED-Beleuchtungsvorrichtung mit hohem Farbwiedergabeindex nach Anspruch 1, wobei die Zahl der LED-Leuchteinheiten mindestens 20 ist.

4. LED-Beleuchtungsvorrichtung mit hohem Farbwiedergabeindex nach Anspruch 1, wobei die Zahl der LED-Leuchteinheiten mindestens 30 ist.

5. LED-Beleuchtungsvorrichtung mit hohem Farbwiedergabeindex nach einem der Ansprüche 1 bis 4, wobei die Koordinaten von mindestens einer der LED-Leuchteinheiten eine Bedingung erfüllen, dass 0,10 ≤ u' ≤ 0,40 und 0,40 ≤ v' ≤ 0,50 ist.

6. LED-Beleuchtungsvorrichtung mit hohem Farbwiedergabeindex nach einem der Ansprüche 1 bis 4, wobei die Koordinaten von mindestens einer der LED-Leuchteinheiten eine Bedingung erfüllen, dass 0,10 ≤ u' ≤ 0,30 und 0,40 ≤ v' ≤ 0,50 ist.

7. LED-Beleuchtungsvorrichtung mit hohem Farbwiedergabeindex nach einem der Ansprüche 1 bis 4, wobei die Koordinaten von mindestens einer der LED-Leuchteinheiten eine Bedingung erfüllen, dass 0,15 ≤ u' ≤ 0,25 und 0,40 ≤ v' ≤ 0,50 ist.

## Revendications

1. Dispositif d'éclairage à diodes électroluminescentes (DEL) avec un indice élevé de rendu de couleurs, comprenant au moins 5 unités lumineuses à diodes électroluminescentes (DEL), chacune des unités lumineuses à DEL possédant des coordonnées de chromaticité (u', v') définies sur le diagramme de chromaticité 1976 de la CIE , une distance entre deux points de coordonnées n'étant pas à chaque fois inférieure à 0,01, une distance entre au moins un des points de coordonnées et tout autre point de coordonnée n'étant pas inférieure à 0,1 et **caractérisé en ce que** les coordonnées d'au moins un des points de coordonnées satisfont à une condition correspondant à 0,10 ≤ u' ≤ 0,45 et 0,30 ≤ v' ≤ 0,50.

2. Dispositif d'éclairage à DEL avec un indice élevé de rendu de couleurs, selon la revendication 1, le nombre d'unités lumineuses à DEL étant au moins de 10.

3. Dispositif d'éclairage à DEL avec un indice élevé de rendu de couleurs, selon la revendication 1, le nombre d'unités lumineuses à DEL étant au moins de 20.

4. Dispositif d'éclairage à DEL avec un indice élevé de rendu de couleurs, selon la revendication 1, le nombre d'unités lumineuses à DEL étant au moins de 30.

5. Dispositif d'éclairage à DEL avec un indice élevé de rendu de couleurs, selon l'une quelconque des revendications 1 à 4, les coordonnées d'au moins une des unités lumineuses à DEL satisfaisant à une condition correspondant à 0,10 ≤ u' ≤ 0,40 et 0,40 ≤ v' ≤ 0,50.

6. Dispositif d'éclairage à DEL avec un indice élevé de rendu de couleurs, selon l'une quelconque des revendications 1 à 4, les coordonnées d'au moins une des unités lumineuses à DEL satisfaisant à une condition correspondant à 0,10 ≤ u' ≤ 0,30 et 0,40 ≤ v' ≤ 0,50.

7. Dispositif d'éclairage à DEL avec un indice élevé de rendu de couleurs, selon l'une quelconque des revendications 1 à 4, les coordonnées d'au moins une des unités lumineuses à DEL satisfaisant à une condition correspondant à 0,15 ≤ u' ≤ 0,25 et 0,40 ≤ v' ≤ 0,50.
